# FASCICULE DE BREVET EUROPEEN

(11) **EP 2 092 564 B1**
(45) Date de publication et mention de la délivrance du brevet: **14.09.2011**
(21) Numéro de dépôt: 07857381.3
(22) Date de dépôt: 11.12.2007
(51) Int. Cl.: H01L 27/146

(54) **STRUCTURE DE PLOTS DE CONNEXION POUR CAPTEUR D'IMAGE SUR SUBSTRAT AMINCI**
BOLZENSTRUKTUR FÜR EINEN BILDSENSOR AUF EINEM VERDÜNNTEN SUBSTRAT
STUD STRUCTURE FOR AN IMAGE SENSOR ON A THINNED SUBSTRATE

(30) Priorité: 20.12.2006 FR 0611083
(43) Date de publication de la demande: 26.08.2009
(73) Titulaire: E2V Semiconductors, 38120 Saint Egrève (FR)
(72) Inventeur: BLANCHARD, Pierre, 38120 Echirolles (FR)
(74) Mandataire: Guérin, Michel
(86) Numéro de dépôt international: PCT/EP2007/063691
(87) Numéro de publication internationale: WO 2008/074691

(56) Documents cités:
- FR-A- 2 887 076
- US-A1- 2004 266 052
- US-A1- 2005 104 148

## Description

L'invention concerne la fabrication de composants électroniques sur substrat semiconducteur aminci. Elle sera décrite principalement à propos d'un capteur d'image sur substrat de silicium aminci, à éclairement par la face arrière.

Les capteurs d'image à substrat aminci ont été conçus pour améliorer les performances colorimétriques des capteurs en permettant l'éclairement du capteur par la face arrière d'une couche de silicium très mince ; cette disposition permet d'éviter la dispersion des photons et des électrons photogénérés dans le substrat et donc d'éviter une diaphotie qui nuirait beaucoup à la colorimétrie puisque les pixels d'image voisins correspondent à des couleurs différentes.

La fabrication d'un capteur d'image sur substrat aminci comprend généralement les étapes suivantes : on part d'un substrat de silicium normal, d'une épaisseur de quelques centaines de micromètres, permettant la manipulation industrielle de tranches collectives d'environ dix à vingt centimètres de diamètre, ce substrat étant revêtu sur une face avant d'une couche épitaxiale de silicium monocristallin, éventuellement isolée du reste du substrat par une couche d'oxyde dans le cas de substrats dits SOI ("silicon on insulator" en anglais). On réalise sur la face avant de cette couche monocristalline la circuiterie électronique nécessaire aux différentes fonctions du capteur (prise d'image essentiellement). Puis on colle le substrat, par sa face avant qui porte cette circuiterie, sur un substrat de report d'une épaisseur suffisante pour la manipulation industrielle, et on amincit le substrat de silicium de départ jusqu'à une épaisseur de quelques micromètres. L'épaisseur très fine de silicium qui en résulte ne permettrait pas la manipulation industrielle de la tranche, et c'est la raison de la présence du substrat de report collé.

Un des problèmes qui se posent pour ces composants est la formation de plots de connexion, pour la liaison du composant avec l'extérieur. Le montage du composant dans un boîtier nécessite en général de souder des fils de liaison entre un plot de connexion métallique prévu sur le composant et des plots métalliques prévus dans le boîtier.

Du fait que le substrat dans lequel ont été formés les circuits électroniques a été collé par sa face avant sur un substrat de report, la face avant n'est plus accessible. On cherche donc à établir une connexion par la face arrière en creusant le substrat aminci, jusqu'à retrouver une plage métallique qui aura été formée au préalable pendant les étapes de fabrication par la face avant.

Un tel procédé est décrit dans le document US 2005/0104148.

On peut notamment creuser le silicium et les couches isolantes qui ont été formées sur la face avant, jusqu'à accéder au premier niveau d'aluminium. On soude alors un fil de connexion en or par la technique classique de « wire-bonding » (soudure de fils), sur la plage d'aluminium mise à nu. Mais cette plage est située dans une cuvette puisqu'il a fallu creuser le silicium et les couches isolantes qui la recouvraient. Cela exclut d'utiliser des méthodes de soudure de fils appelées "wedge bonding" par opposition à "ball bonding", dans lesquelles le fil (en général en aluminium) à souder arrive trop obliquement pour pouvoir être soudé à l'intérieur d'une cuvette. C'est pourquoi on est obligé de continuer à utiliser une soudure de fils d'or, même dans des cas où on préfèrerait un fil d'aluminium. De plus, la cuvette est formée dans un matériau semiconducteur, pas dans un matériau isolant, et il y a donc des risques de court-circuit entre le fil et les bords de la cuvette.

Par ailleurs, il faut aussi remarquer que les plages d'aluminium qui servent à la soudure de fils doivent être en principe plus épaisses que les couches d'aluminium qui sont utilisées pour les fonctions ordinaires d'interconnexion dans le circuit intégré. Or, la technique expliquée ci-dessus permet en pratique d'accéder seulement au premier niveau d'aluminium (sauf à vouloir creuser encore plus profond), et ce niveau n'a aucune raison d'être suffisamment épais pour autoriser une soudure. Pour adapter cette solution à une industrialisation, il faudrait donc prévoir un premier niveau d'aluminium plus épais que ce qui est en général nécessaire ; cela oblige à changer le processus de fabrication standard, ce qui n'est pas souhaitable.

C'est pourquoi on propose ici un nouveau procédé pour réaliser des plots de connexion d'un composant électronique à substrat aminci.

Le procédé comprend les étapes suivantes :
- on réalise un circuit intégré sur substrat non aminci, dans lequel on prévoit une portion de couche de silicium polycristallin dédiée à la connexion du plot, cette portion étant en contact avec une connexion interne du circuit intégré ;
- on reporte le circuit sur un substrat de report, puis on amincit sa face arrière ;
- on ouvre un via dans la face arrière amincie pour accéder au silicium polycristallin,
- on dépose une couche métallique sur la face arrière et dans le via, et on grave cette couche pour délimiter un plot qui est en contact avec la connexion interne du circuit intégré par l'intermédiaire du silicium polycristallin.

Le procédé peut comprendre les opérations suivantes :
- on réalise le circuit intégré à partir de la face avant d'un premier substrat portant une couche semiconductrice superficielle, cette réalisation comprenant notamment la formation, sur la face avant de la couche semiconductrice, d'une couche isolante recouverte de la portion de couche de silicium polycristallin, puis le dépôt et la gravure d'une alternance de couches isolantes et de couches métalliques avec des interconnexions entre les différentes couches métalliques et des interconnexions entre la couche de silicium polycristallin et au moins une des couches métalliques,
- on reporte le substrat par sa face avant contre le substrat de report ;
- on amincit le premier substrat par sa face arrière pour ne conserver qu'une couche semiconductrice d'environ 2 à 30 micromètres d'épaisseur ;
- on creuse, par la face arrière de la couche semiconductrice, une ouverture dans toute l'épaisseur de la couche semiconductrice au-dessus d'une plage de couche isolante recouverte de silicium polycristallin ;
- on élimine la couche isolante au fond de l'ouverture pour mettre à nu le silicium polycristallin, avant de déposer et graver la couche métallique qui viendra en contact avec le silicium polycristallin dans l'ouverture.

Il est souhaitable d'éviter de prévoir un isolement électrique entre la couche métallique et la couche semiconductrice, car cela nécessiterait des opérations supplémentaires. C'est pourquoi on prévoit de préférence que le plot de connexion est formé sur un îlot de couche semiconductrice complètement isolé du reste de la couche semiconductrice. Cet îlot est délimité par creusement d'une tranchée tout autour de l'îlot pendant la formation de l'ouverture permettant d'accéder au silicium polycristallin.

Ces opérations sont faites sur tranche, c'est-à-dire en fabrication collective de plusieurs puces de circuit intégré. Ultérieurement, la tranche sera découpée en puces individuelles avant de monter les puces dans des boîtiers. Lors du montage de la puce dans son boîtier, on soudera un fil de connexion sur le métal formant un plot de connexion sur l'îlot.

Comme on soude le fil sur l'îlot et non dans le fond d'une cuvette, on peut très bien utiliser aussi bien des méthodes de soudure de fils d'aluminium (wedge bonding), qui sont particulièrement fiables, que des méthodes de soudure de fils d'or (ball bonding) plus classiques. De plus, il n'y a pas de risque de court-circuit entre le fil et la couche semiconductrice puisqu'il n'y a pas de cuvette.

On peut choisir l'épaisseur désirée pour la couche métallique qui sert à former le plot, sans avoir à choisir une épaisseur particulière pour les niveaux conducteurs qui ont été formés à partir de la face avant.

L'épaisseur d'oxyde à graver pour atteindre la couche de silicium polycristallin peut être très mince : elle peut être égale à l'épaisseur des oxydes minces qui isolent les grilles de transistors MOS dans le circuit intégré (ou les grilles de transfert de charges pour un capteur d'image CCD). La gravure de cet oxyde est particulièrement facile car la sélectivité de gravure de l'oxyde par rapport au silicium peut être excellente.

Le contact se fait entre la couche métallique qui forme le plot et une couche de silicium polycristallin ; la couche métallique sera en principe de l'aluminium et le contact entre l'aluminium et le silicium polycristallin est particulièrement facile à établir ; il n'y a pas de risque de corrosion de l'aluminium de premier niveau qui n'est pas mis à nu en vue de ce contact.

Il n'est pas nécessaire d'ouvrir une large surface de silicium du substrat pour dégager un plot conducteur sous le silicium comme il fallait le faire auparavant. Il suffit d'ouvrir des trous ponctuels (en forme de vias) dans le silicium pour atteindre le silicium polycristallin, et il suffit de creuser une tranchée d'isolation autour du plot.

Outre le procédé qui vient d'être décrit, l'invention concerne aussi un composant électronique comportant un circuit intégré réalisé sur la face avant d'un premier substrat de silicium aminci, le substrat aminci comportant une couche semiconductrice mince d'environ 2 à 30 micromètres d'épaisseur, le premier substrat étant monté par sa face avant sur un substrat de report, caractérisé en ce que le composant comporte sur la face arrière accessible de la couche semiconductrice au moins un plot de connexion extérieure formé par une portion de couche métallique déposée sur la couche semiconductrice, la couche métallique venant en contact directement, à travers une ouverture formée dans l'îlot, avec une couche de silicium polycristallin formée sur la face avant du premier substrat aminci, la couche de silicium polycristallin étant elle-même en contact avec une couche métallique d'interconnexion interne formée sur la face avant du substrat de silicium aminci.

On notera que dans l'hypothèse où le substrat de report est lui-même une puce de circuit intégré, les faces avant des deux circuits intégrés étant collées l'une contre l'autre, le procédé de fabrication selon l'invention peut servir aussi à connecter les deux circuits intégrés. Dans ce cas, la portion de couche métallique formée sur la face arrière de la couche semiconductrice comprend non seulement le plot de connexion mais aussi une liaison conductrice reliant le plot à une couche conductrice de la face avant du deuxième circuit intégré (celui qui constitue le substrat de report). Cette liaison passe à travers une autre ouverture formée dans la couche semiconductrice et à travers les couches isolantes qui séparent la couche semiconductrice de la couche conductrice du deuxième circuit intégré.

D'autres caractéristiques et avantages de l'invention apparaîtront à la lecture de la description détaillée qui suit et qui est faite en référence aux dessins annexés dans lesquels :
- les figures 1 et 2 représente deux étapes de fabrication d'un circuit intégré sur substrat aminci, dans lequel la formation du plot de connexion extérieure présente des inconvénients ;
- la figure 3 représente une étape de fabrication du circuit intégré dans le procédé selon l'invention, avant report et amincissement ;
- la figure 4 représente les étapes de report et d'amincissement ;
- la figure 5 représente l'étape d'ouverture de la face arrière avant dépôt d'un plot de connexion ;
- la figure 6 représente le composant selon l'invention avec son plot de connexion.

L'invention sera décrite à propos d'un capteur d'image sur silicium, pour la capture d'image visible aux longueurs d'onde auxquelles le silicium est sensible. L'invention est applicable cependant à des capteurs sur substrats d'autres matériaux et pour d'autres longueurs d'onde (infrarouge par exemple). Elle est applicable également pour l'association d'un circuit intégré sur substrat aminci avec un circuit intégré classique sur substrat non aminci, le circuit classique servant dans ce cas de substrat de report pour le substrat aminci mais des connexions étant établies entre les deux circuits et les plots de connexion avec l'extérieur se trouvant sur la face arrière accessible du circuit sur substrat aminci.

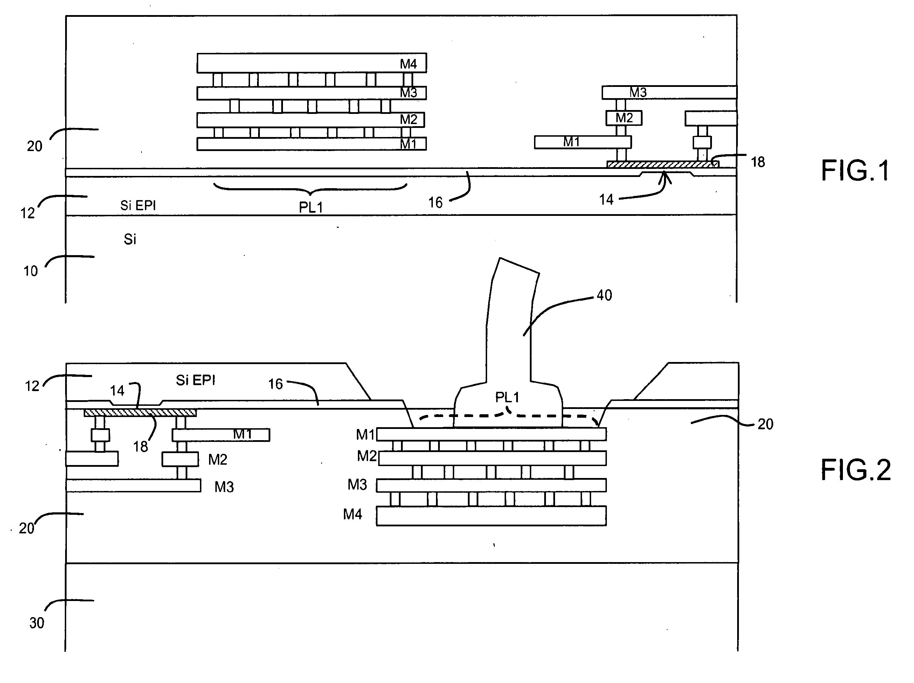

Sur la figure 1, on a représenté la structure d'un circuit intégré réalisé avant report sur un substrat de report.

Le circuit intégré est fabriqué par diverses opérations faites sur la face avant d'un substrat 10 ; le substrat est en général un substrat de silicium portant une couche épitaxiale 12 ; ces opérations de face avant comprennent des dépôts de couches, des gravures de couches, des diffusions d'impuretés, des traitements thermiques, etc. Toutes ces opérations dites de « front-end » (opérations amont) sont faites collectivement sur tranche avant division de la tranche en puces individuelles. Les puces sont ensuite montées en boîtier individuel (opérations aval, ou « back-end »).

Parmi les opérations de front-end qui sont classiques et qu'on pourra reprendre sans modifications dans le procédé selon l'invention, on trouve au moins :
- la formation à la surface du silicium 12 de portions d'une couche isolante mince 14 (oxyde de silicium de préférence) qui sera située sous les grilles de transistors MOS, ou sous les grilles de transfert de charges dans le cas de capteurs d'image à transfert de charges (capteurs CCD) ;
- la formation de portions d'une couche isolante plus épaisse 16 à d'autres endroits, soit par dépôt soit par oxydation thermique du silicium ;
- le dépôt et la gravure d'une couche de silicium polycristallin 18 pour former les grilles de transistors ou les grilles de transfert de charges ;
- le dépôt d'une alternance de couches isolantes et conductrices permettant de définir les interconnexions internes au circuit intégré ; différentes techniques peuvent être utilisées ; on a représenté sur la figure 1 un exemple dans lequel plusieurs couches conductrices (de préférence des couches à base d'aluminium) sont réparties en plusieurs niveaux désignés par M1 à M4 et sont reliées les unes aux autres par des vias formés d'un autre métal conducteur (tungstène ou titane-tungstène), ces vias traversant les couches isolantes ; la dernière couche isolante de cette alternance est une couche de planarisation finale au-dessus des interconnexions.

L'ensemble des couches isolantes formées au cours de l'alternance de dépôts de couches isolantes et conductrices a été représenté sous forme d'une couche isolante unique 20 dans laquelle sont noyées les portions de couches conductrices des niveaux M1 à M4 ainsi que les vias conducteurs entre ces couches ou entre ces couches et la couche 18.

On n'a pas représenté, pour ne pas alourdir la figure, les diffusions d'impuretés dans le silicium de la couche épitaxiale 12, qui sont faites avant le dépôt de l'alternance de couches isolantes et conductrices.

Sur la partie gauche de la figure 1, on a plus spécialement représenté les couches métalliques qui serviront à la prise de contact pour un plot de connexion avec l'extérieur. Le contact se fera sur le premier niveau d'aluminium M1, dans une zone PL1. On peut prévoir que cette zone PL1 du niveau M1 est surplombée par des zones semblables des niveaux M2, M3, M4, avec des vias ponctuels de connexion entre ces zones, mais ce n'est pas obligatoire.

La suite de la fabrication du circuit est alors la suivante : on reporte le substrat de circuit intégré par sa face avant planarisée (en haut sur la figure 1) sur un substrat de report. Le collage se fait par exemple par adhérence moléculaire entre deux surfaces extrêmement planes.

Puis on continue les opérations par la face arrière du substrat de départ puisque la face avant n'est plus accessible.

On amincit très fortement le substrat 10 jusqu'à ne garder qu'une couche épitaxiale 12 extrêmement mince (de 2 à 5 micromètres pour un circuit de technologie CMOS, et de 5 à 20 micromètres pour un capteur d'image de technologie CCD, voire un peu plus pour des images infrarouge).

Après amincissement, on effectue les opérations nécessaires à la réalisation de plots de connexion extérieure.

La figure 2 représente la structure ainsi amincie avec un plot de connexion comme on pourrait envisager de le réaliser mais avec certains inconvénients que l'invention vise à éliminer. Le circuit intégré est retourné, c'est-à-dire que la face avant sur laquelle ont été faites les opérations de front end est maintenant tournée vers le bas de la figure. Elle est collée contre le substrat de report 30. La face arrière du circuit intégré, en haut de la figure ne comporte pratiquement plus que la couche épitaxiale 12, voire même une partie seulement de cette couche.

La réalisation du plot consiste seulement à ouvrir le silicium de la couche amincie 12 sur toute sa profondeur dans toute la zone PL1 correspondant au plot à réaliser ; on met ainsi à nu la couche isolante 16 qui recouvrait le silicium à la figure 1 ; on ouvre ensuite cette couche isolante 16, ainsi que la partie de couche isolante 20 sous-jacente, jusqu'à mettre à nu la couche métallique de premier niveau M1 dans toute la zone PL1. L'aluminium à nu sert de plot de connexion et un fil de connexion 40 peut y être soudé.

Mais les inconvénients de cette solution sont multiples :
1. la couche d'aluminium de premier niveau risque d'être trop mince dans une technologie front end standard ; en effet, c'est plutôt le métal de dernier niveau M4 qui est en général plus épais car il sert à former les plots de connexion dans les technologies non amincies où les plots sont accessibles par la face avant ;
2. on pourrait choisir d'augmenter l'épaisseur du métal de premier niveau M1, mais cela oblige à modifier la technologie standard à chaque fois qu'on fait un circuit sur substrat aminci ;
3. on pourrait choisir de creuser plus profondément pour aller chercher le dernier niveau de métal M4 (plus épais) pour y souder le fil de connexion ; mais cela rendrait le soudage du fil plus difficile à cause de la profondeur supplémentaire du plot ;
4. du fait que le plot est enfoncé dans une cuvette creusée dans le silicium 12 et l'isolant 20, on est en pratique obligé de souder un fil d'or et non un fil d'aluminium, par une technique qui fait arriver le fil verticalement et non obliquement sur le plot de connexion ; la cuvette empêche le fil d'arriver en oblique, sauf à la faire très large, ce qui serait gênant ; ;
5. Le dénudage du métal M1 (qui reste dénudé après soudure du fil) peut être cause de corrosion future de ce métal.

Pour remédier autant que possible à ces inconvénients, l'invention propose un procédé qui tire parti du fait que dans tous les circuits intégrés de technologie MOS ou CCD on dispose d'un niveau de grille de silicium polycristallin (couche 18 des figures 1 et 2) qui sert à faire des transistors ou des grilles de transfert de charges. Selon l'invention, on va disposer une portion de cette couche à l'endroit du plot de connexion à réaliser et on va relier cette portion à une connexion métallique interne (par exemple une connexion du métal de premier niveau M1) en fonction du rôle attribué au plot dans le circuit intégré (plot d'alimentation, plot de masse, plot d'entrée, plot de sortie, etc.). Cette portion de couche de silicium polycristallin servira d'intermédiaire entre le plot de connexion de face arrière et les interconnexions métalliques internes.

Lors du traitement de face avant, avant report et amincissement, on grave donc la couche de silicium polycristallin pour définir non seulement les grilles de transistors ou de transfert, mais aussi une portion de couche réservée à la réalisation ultérieure du plot. Le plot sera réalisé lors du traitement de face arrière après amincissement du substrat. Et de plus, toujours lors du traitement de face avant, et après gravure de la couche de silicium polycristallin on établit le contact nécessaire entre cette couche et le reste du circuit intégré, par exemple entre un contact entre le silicium polycristallin et une portion de couche de métal de premier niveau M1 qui la surplombe. Le reste du traitement de face avant est inchangé, ainsi que le report et l'amincissement.

Lors du traitement de face arrière après amincissement, on ouvrira le silicium localement pour accéder à la couche de silicium polycristallin, puis on déposera une couche métallique venant en contact avec le silicium polycristallin. C'est cette couche de face arrière, et non une couche déposée lors du traitement de face avant, qui constituera un plot de connexion.

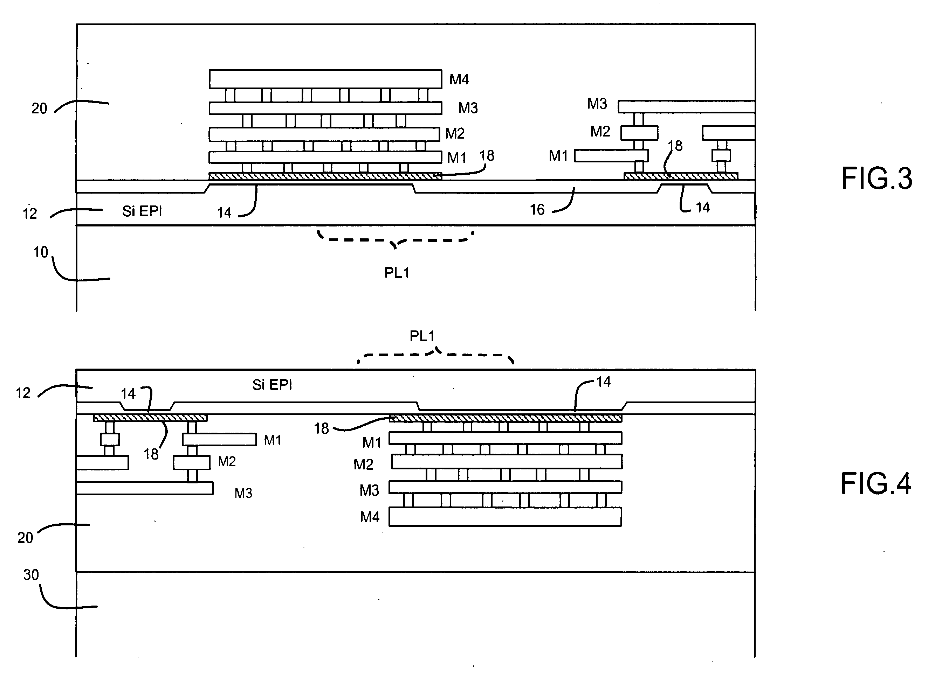

Ainsi, la figure 3 représente le circuit intégré selon l'invention après le traitement de face avant ; la face avant est en haut. On a indiqué par la référence PL1 la zone dans laquelle on trouvera le plot de connexion. Une portion de couche de silicium polycristallin reliée au premier niveau de métal M1 surplombe en partie la zone PL1. La liaison électrique entre le silicium polycristallin et le métal peut se faire par un ou plusieurs vias classiques, par exemple en tungstène ou alliage tungstène/titane.

Des portions de couches des autres niveaux, reliées les unes aux autres par des vias, peuvent surplomber la portion de couche 18 mais ce n'est pas obligatoire. La portion de couche de silicium polycristallin qui servira pour la constitution du plot de connexion peut être située sur une couche d'isolant mince 14 (comme sur la figure 3) ou sur une couche d'isolant plus épais 16.

Les étapes de fabrication à partir de la face avant sont standard, seul le motif de gravure des couches et des interconnexions différent de la technique expliquée en référence à la figure 1.

Après la fin des étapes de fabrication sur tranche à partir de la face avant, on colle la tranche par sa face avant contre le substrat de report. Les étapes suivantes se font à partir de la face arrière.

La figure 4 représente le circuit intégré retourné, face arrière vers le haut, après report sur un substrat de report 30 et après amincissement du silicium jusqu'à quelques micromètres d'épaisseur.

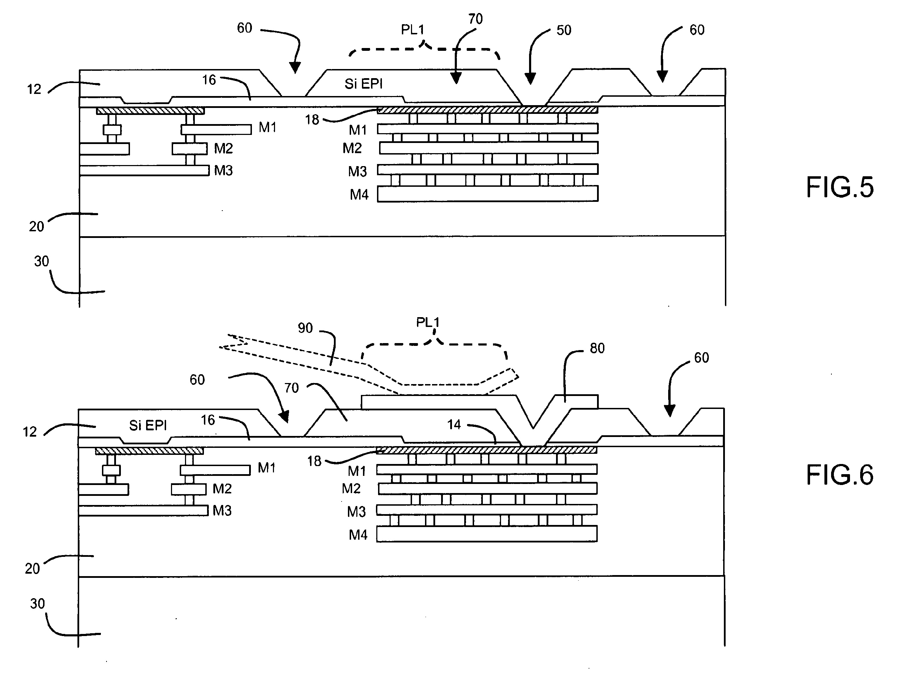

La figure 5 représente l'étape de fabrication suivante : on grave le silicium de la couche semiconductrice 12 sur toute son épaisseur de manière à former au moins une ouverture 50 au-dessus de la portion de couche de silicium polycristallin réservée à la réalisation du plot de connexion.

De préférence, on profite de cette gravure pour creuser aussi, sur toute l'épaisseur du silicium et jusqu'à la couche isolante 16, une tranchée périphérique 60 qui entoure complètement à la fois la zone PL1 réservée au plot de connexion et l'ouverture 50. Cette tranchée 60 délimite un îlot de silicium monocristallin 70 complètement isolé électriquement du reste du silicium et englobant la zone PL1. Il y a un îlot différent pour chaque plot de connexion.

On notera que, contrairement à ce qu'on faisait dans le cas de la figure 2, la gravure du silicium 12 ne se fait pas dans toute la zone PL1 mais seulement autour de cette zone (pour l'isolement de l'îlot) et en des points de contact ponctuels (pour un contact en un ou plusieurs points avec la couche 18). On notera aussi que la gravure du silicium est particulièrement facile car elle s'arrête sur la couche isolante 14 ou 16 (oxyde de silicium en général) et non sur de l'aluminium.

On élimine alors la couche isolante mince 14 qui est présente au fond de l'ouverture 50, jusqu'à mettre à nu le silicium polycristallin. Là encore, cette opération est très facile en raison de la sélectivité de gravure entre silicium et oxyde. Il n'y a même pas besoin de masque de gravure.

La réalisation du plot de connexion proprement dit peut alors être faite : on dépose une couche métallique 80, de préférence de l'aluminium, éventuellement un sandwich comprenant une couche d'aluminium et du nitrure de titane. La couche se dépose sur la face arrière du silicium polycristallin et dans les ouvertures et tranchées. On grave cette couche pour délimiter un plot confiné sur l'îlot de silicium et une zone qui recouvre l'ouverture 50 pour venir établir un contact entre le plot et la couche de silicium polycristallin dénudée au fond de l'ouverture. Le métal est éliminé dans la tranchée 60. L'épaisseur de l'aluminium est choisie suffisante pour permettre de jouer le rôle de plot de connexion.

L'aluminium peut servir aussi à d'autres usages, tels qu'un contact de face arrière pour une matrice de prise d'image.

La fabrication collective est alors terminée. Après découpe de la tranche en puces individuelles, on monte les puces en boîtier, et on peut souder un fil de connexion sur le plot par la méthode souhaitée, le plot n'étant pas enfoncé dans une cuvette.

On a représenté en pointillés sur la figure 6 le fil de connexion 90 qui sera soudé après découpe en puces individuelles. On voit que ce fil peut arriver avec une incidence très oblique.

Sur les figures, on a considéré que l'ouverture 50 pour la prise de contact était décalée par rapport à la zone de plot PL1 sur laquelle sera soudé le fil. On pourrait aussi prévoir que l'ouverture 50 est située dans la zone PL1. L'ouverture 50 est ponctuelle, elle peut occuper une surface faible par rapport à la surface du plot. Il peut y avoir plusieurs ouvertures 50 pour mieux faire passer les courants ; elles sont distribuées dans la zone PL1 ou autour de la zone PL1 mais toujours dans l'îlot isolé 70.

Comme on l'a mentionné précédemment, le substrat de report peut être un circuit intégré classique sur substrat non aminci, par exemple dans une application où on collerait un capteur d'image aminci par sa face avant sur la face avant d'un circuit de traitement des images recueillies par le capteur. Dans ce cas, il faut connecter les deux circuits. Pour cela, on prévoit que la gravure du silicium monocristallin 12 comprend aussi la formation d'une ouverture supplémentaire (à l'intérieur de l'îlot 70 donc dans le périmètre de la tranchée 60), cette ouverture n'étant pas située en regard de couches conductrices telles que 18, M1, M2, M3, M4. Ensuite, on prévoit une étape supplémentaire de gravure de couches isolantes pour créer une ouverture à travers toute la superposition de couches isolantes 20 jusqu'à la face avant du circuit intégré non aminci, et on poursuit la gravure jusqu'à rencontrer un niveau conducteur du deuxième circuit intégré non aminci. Ce niveau conducteur est par exemple un conducteur de dernier niveau (tel que le niveau M4 décrit précédemment) du deuxième circuit. Lors du dépôt de la couche métallique 80, celle-ci vient en contact à travers l'ouverture ainsi formée, avec ce niveau conducteur. Lors de la gravure de la couche métallique 80, on délimite non seulement le plot de connexion mais aussi une liaison électrique qui relie ce plot au deuxième circuit intégré.

## Revendications

1. Procédé pour réaliser des plots de connexion d'un composant électronique à substrat aminci, comprenant les étapes suivantes :
- réaliser un circuit intégré sur un substrat de silicium non aminci (10), dans lequel on prévoit une portion de couche de silicium polycristallin (18) dédiée à la connexion du plot, cette portion étant en contact avec une connexion interne (M1) du circuit intégré ;
- reporter la face avant du circuit sur un substrat de report (30), puis amincir la face arrière (12) du substrat de silicium (10);
- ouvrir un via (50) dans la face arrière amincie (12) pour accéder au silicium polycristallin,
- déposer une couche métallique (80) sur la face arrière (12) et dans le via (50), et graver cette couche (80) pour délimiter un plot qui est en contact avec la connexion interne (M1) du circuit intégré par l'intermédiaire du silicium polycristallin (18).

2. Procédé selon la revendication 1, **caractérisé en que** les opérations de réalisation du plot comprennent les étapes suivantes :
- réalisation du circuit intégré à partir de la face avant d'un premier substrat (10) portant une couche semiconductrice (12) superficielle, cette réalisation comprenant notamment la formation, sur la face avant de la couche semiconductrice (12), d'une couche isolante (14, 16) recouverte de la portion de couche de silicium polycristallin (18), puis le dépôt et la gravure d'une alternance de couches isolantes et de couches métalliques (111, 112, 113, 114) avec des interconnexions entre les différentes couches métalliques (111, 112, 113, 114) et des interconnexions entre la couche de silicium polycristallin (18) et au moins une des couches métalliques (111, 112, 113, 114),
- report du substrat par sa face avant contre le substrat de report (30) ;
- amincissement du premier substrat (10) par sa face arrière pour ne conserver qu'une couche semiconductrice (12) de 2 à 30 micromètres d'épaisseur ;
- creusement, par la face arrière de la couche semiconductrice (12), d'une ouverture (50) dans toute l'épaisseur de la couche semiconductrice (12) au-dessus d'une plage de couche isolante (14, 16) recouverte de silicium polycristallin (18);
- élimination de la couche isolante (14, 16) au fond de l'ouverture (50) pour mettre à nu le silicium polycristallin (18), avant de déposer et graver la couche métallique (58) qui viendra en contact avec le silicium polycristallin (18) dans l'ouverture (50).

3. Procédé selon la revendication 2, **caractérisé en ce que**, lors de l'opération de gravure de la couche semiconductrice (12), on grave une tranchée périphérique (60) entourant complètement à la fois le plot de connexion qui sera ultérieurement délimité et l'ouverture formée dans la couche semiconductrice (12).

4. Procédé selon l'une des revendications 2 à 3, **caractérisé en ce que** le dépôt métallique (80) fait sur la face arrière est un dépôt à base d'aluminium.

5. Procédé selon l'une des revendications 2 à 4, **caractérisé en ce que** le substrat de report (30) est un substrat sur la face avant duquel a été intégré un deuxième circuit intégré à connecter avec le circuit intégré formé sur le substrat aminci (12); **caractérisé en ce que** lors de l'opération de gravure de la couche semiconductrice (12) on forme une ouverture supplémentaire, et on grave ultérieurement les couches isolantes situées sous cette ouverture jusqu'à la face avant du deuxième circuit intégré et on poursuit cette gravure jusqu'à mettre à nu un conducteur du deuxième circuit intégré avant de procéder à l'étape de dépôt d'une couche métallique sur la face arrière de la couche semiconductrice (12) et avant de graver cette couche pour délimiter à la fois un plot de connexion relié au circuit intégré sur substrat aminci et une liaison conductrice vers le deuxième circuit intégré à travers l'ouverture supplémentaire.

6. Composant électronique comportant un circuit intégré réalisé sur la face avant d'un premier substrat de silicium aminci, le substrat aminci comportant une couche semiconductrice mince (12) de 2 à 30 micromètres d'épaisseur, le premier substrat étant monté par sa face avant sur un substrat de report (30), **caractérisé en ce que** le composant comporte sur la face arrière accessible de la couche semiconductrice (12) au moins un plot de connexion extérieure (PL1) formé par une portion de couche métallique (80) déposée sur la couche semiconductrice, la couche métallique (80) venant en contact directement, à travers une ouverture (50) formée dans un îlot du premier substrat aminci, avec une couche de silicium polycristallin (18) formée sur la face avant du premier substrat aminci, la couche de silicium polycristallin (18) étant elle-même en contact avec une couche métallique (M1) du circuit intégré formée sur la face avant du substrat de silicium aminci.

7. Composant selon la revendication 6, **caractérisé en ce que** l'ouverture (50) formée dans la couche semiconductrice (12) est formée dans un îlot de couche semiconductrice entièrement isolé électriquement, par une tranchée entourant cet îlot, du reste de la couche semiconductrice (12).

8. Composant électronique selon l'une des revendications 6 et 7, **caractérisé en ce que** le substrat de report (30) est une puce de circuit intégré, les faces avant des deux circuits intégrés étant collées l'une contre l'autre, la portion de couche métallique (80) formée sur la face arrière de la couche semiconductrice (12) comprenant, outre le plot de connexion, une liaison conductrice reliant le plot à une couche conductrice de la face avant du deuxième circuit intégré à travers une autre ouverture formée dans la couche semiconductrice et à travers les couches isolantes qui séparent la couche semiconductrice de la couche conductrice du deuxième circuit intégré.

## Claims

1. A method for producing connection pads for an electronic component having a thinned substrate, comprising the following steps:
- producing an integrated circuit on an unthinned silicon substrate (10), in which a portion of a polycrystalline silicon layer (18) dedicated for the connection of the pad is provided, this portion being in contact with an internal connection (M1) of the integrated circuit;
- transferring the front face of the circuit is transferred onto a transfer substrate (30) and then thinning the back face (12) of the silicon substrate (10);
- opening a via (50) in the thinned back side (12) in order to gain access to the polycrystalline silicon; and
- depositing a metal layer (80) on the back face (12) and in the via (50), and etching this layer (80) so as to define a pad which is in contact with the internal connection (M1) of the integrated circuit by way of the polycrystalline silicon (18).

2. The method as claimed in claim 1, **characterized in that** the pad production operations comprise the following steps:
- the integrated circuit is produced from the front side of a first substrate (10) bearing a surface semiconductor layer (12), this production step comprising notably the formation, on the front side of the semiconductor layer (12), of an insulating layer (14, 16) covered with the portion of polycrystalline silicon layer (18), and then the deposition and etching of an alternation of insulating layers and metal layers (M1, M2, M3, M4) with interconnects between the various metal layers (M1, M2, M3, M4) and interconnects between the polycrystalline silicon layer (18) and at least one of the metal layers (M1, M2, M3, M4);
- the substrate (10) is transferred via its front side onto the transfer substrate (30) and bonded thereto;
- the first substrate (10) is thinned via its back side so as to retain only a semiconductor layer (12) of 2 to 30 microns in thickness;
- an aperture (50) is cut, via the back side of the semiconductor layer(12), through the entire thickness of the semiconductor layer (12) on top of an insulating layer area (14, 16) covered with polycrystalline silicon (18); and
- the insulating layer (14, 16) is removed from the bottom of the aperture (50) so as to bare the polysilicon (18), before the metal layer (80) that will come into contact with the polycrystalline silicon (18) in the aperture (50) is deposited and etched.

3. The method as claimed in claim 2, **characterized in that**, during the operation of etching the semiconductor layer (12), a peripheral trench (60) is etched that completely surrounds both the connection pad which will subsequently be defined and the aperture formed in the semiconductor layer (12).

4. The method as claimed in either of claims 2 and 3, **characterized in that** the metal deposited (80) on the back side is an aluminum-based metal.

5. The method as claimed in one of claims 2 to 4, **characterized in that** the transfer substrate (30) is a substrate on the front side of which a second integrated circuit, to be connected to the integrated circuit formed on the thinned substrate (12), has been integrated, **characterized in that**, during the step of etching the semiconductor layer (12), an additional aperture is formed and the insulating layers located beneath this aperture are subsequently etched down to the front side of the second integrated circuit, and this etching is continued until a conductor of the second integrated circuit is bared before the step of depositing a metal layer on the back side of the semiconductor layer (12) is carried out and before this layer is etched so as to delimit both a connection pad connected to the integrated circuit on the thinned substrate and a conducting link to the second integrated circuit through the additional aperture.

6. An electronic component comprising an integrated circuit produced on the front side of a thinned first silicon substrate, the thinned substrate comprising a thin semiconductor layer (12) of 2 to 30 microns in thickness, the first substrate being mounted via its front side on a transfer substrate (30), **characterized in that** the component includes, on the accessible back side of the semiconductor layer (12), at least one external connection pad (PL1) formed by a portion of the metal layer (80) deposited on the semiconductor layer, the metal layer (80) being in direct contact, through an aperture (50) formed in an island of the first thinned substrate, with a polycrystalline silicon layer (18) formed on the front side of the thinned first substrate, the polycrystalline silicon layer (18) itself being in contact with a metal layer (M1) of the integrated circuit formed on the front side of the thinned silicon substrate.

7. The component as claimed in claim 6, **characterized in that** the aperture (50) formed in the semiconductor layer (12) is formed in a semiconductor layer island that is entirely isolated electrically, by a trench surrounding this island, from the rest of the semiconductor layer.

8. The electronic component as claimed in either of claims 6 and 7, **characterized in that** the transfer substrate (30) is an integrated-circuit chip, the front sides of the two integrated circuits being bonded to each other, the portion of the metal layer (80) formed on the back side of the semiconductor layer (12) comprising, apart from the connection pad, a conducting link that connects the pad to a conducting layer on the front side of the second integrated circuit through another aperture formed in the semiconductor layer and through the insulating layers that separate the semiconductor layer from the conducting layer of the second integrated circuit.

## Patentansprüche

1. Verfahren zum Herstellen von Verbindungskontaktstücken eines elektronischen Bauelements mit verdünntem Substrat, das die folgenden Schritte beinhaltet:
- Herstellen einer integrierten Schaltung auf einem unverdünnten Siliciumsubstrat (10), in dem ein Teil einer polykristallinen Siliciumschicht (18) für die Verbindung des Kontaktstücks vorgesehen ist, wobei dieser Teil mit einer internen Verbindung (M1) der integrierten Schaltung in Kontakt ist,
- Übertragen der Vorderseite der Schaltung auf ein Übertragssubstrat (30), dann Verdünnen der Rückseite (12) des Siliciumsubstrats (10);
- Öffnen einer Durchkontaktierung (50) in der verdünnten Rückseite (12) zum Zugreifen auf das polykristalline Silicium,
- Auftragen einer metallischen Schicht (80) auf die Rückseite (12) und in der Durchkontaktierung (50) und Ätzen dieser Schicht (80) zum Begrenzen eines Kontaktstücks, das mit der internen Verbindung (M1) der integrierten Schaltung mittels des polykristallinen Siliciums (18) in Kontakt ist.

2. Verfahren nach Anspruch 1, **dadurch gekennzeichnet**, das die Abläufe des Herstellens des Kontaktstücks die folgenden Schritte beinhalten:
- Herstellen der integrierten Schaltung von der Vorderseite eines ersten Substrats (10), das eine Halbleiterdeckschicht (12) trägt, wobei diese Herstellung insbesondere die Bildung einer von dem Teil der polykristallinen Siliciumschicht (18) bedeckten Isolierschicht (14, 16) auf der Vorderseite der Halbleiterschicht (12), dann das Auftragen und Ätzen einer abwechselnden Folge von Isolierschichten und metallischen Schichten (M1, M2, M3, M4) mit Verbindungen zwischen den verschiedenen metallischen Schichten (M1, M2, M3, M4) und Verbindungen zwischen der polykristallinen Siliciumschicht (18) und wenigstens einer der metallischen Schichten (M1, M2, M3, M4) beinhaltet,
- Übertragen des Substrats (10) mit seiner Vorderseite auf das Übertragssubstrat (30);
- Verdünnen des ersten Substrats (10) an seiner Rückseite, um nur eine Halbleiterschicht (12) von 2 bis 30 Mikrometer Dicke zu behalten;
- Aushöhlen, an der Rückseite der Halbleiterschicht (12), einer Öffnung (50) in der gesamten Dicke der Halbleiterschicht (12) über einem Bereich der mit polykristallinem Silicium (18) bedeckten Isolierschicht (14, 16),
- Entfernen der Isolierschicht (14, 16) am Boden der Öffnung (50), um das polykristalline Silicium (18) zu exponieren, danach Auftragen und Ätzen der metallischen Schicht (80), die mit dem polykristallinen Silicium (18) in der Öffnung (50) in Kontakt kommt.

3. Verfahren nach Anspruch 2, **dadurch gekennzeichnet, dass** beim Ätzen der Halbleiterschicht (12) ein peripherer Graben (60) geätzt wird, der gleichzeitig das später begrenzte Verbindungskontaktstück und die in der Halbleiterschicht (12) gebildete Öffnung vollständig umgibt.

4. Verfahren nach einem der Ansprüche 2 bis 3, **dadurch gekennzeichnet, dass** der Metallauftrag (80) auf die Rückseite ein Auftrag auf Aluminiumbasis ist.

5. Verfahren nach einem der Ansprüche 2 bis 4, **dadurch gekennzeichnet, dass** das Übertragssubstrat (30) ein Substrat ist, auf dessen Vorderseite eine zweite integrierte Schaltung integriert wurde, die mit der auf dem verdünnten Substrat (12) gebildeten integrierten Schaltung zu verbinden ist, **dadurch gekennzeichnet, dass** beim Ätzen der Halbleiterschicht (12) eine zusätzliche Öffnung gebildet wird und später die unter dieser Öffnung befindlichen Isolierschichten bis zur Vorderseite der zweiten integrierten Schaltung geätzt werden und dieses Ätzen fortgesetzt wird, bis ein Leiter der zweiten integrierten Schaltung exponiert ist, danach mit dem Schritt des Auftragens einer metallischen Schicht auf die Rückseite der Halbleiterschicht (12) fortgefahren und dann diese Schicht geätzt wird, um gleichzeitig ein mit der integrierten Schaltung auf dem verdünnten Substrat verbundenes Verbindungskontaktstück und eine Leitungsverbindung mit der zweiten integrierten Schaltung durch die zusätzliche Öffnung zu begrenzen.

6. Elektronisches Bauelement, umfassend eine integrierte Schaltung, die auf der Vorderseite eines ersten verdünnten Siliciumsubstrats hergestellt ist, wobei das verdünnte Substrat eine dünne Halbleiterschicht (12) von 2 bis 30 Mikrometer Dicke umfasst, wobei das erste Substrat mit seiner Vorderseite auf einem Übertragssubstrat (30) montiert ist, **dadurch gekennzeichnet, dass** das Bauelement auf der zugängigen Rückseite der Halbleiterschicht (12) wenigstens ein äußeres Verbindungskontaktstück (PL1) umfasst, das von einem auf die Halbleiterschicht aufgetragenen Metallschichtabschnitt (80) gebildet wird, wobei die Metallschicht (80) durch eine in einer Insel des ersten verdünnten Substrats gebildete Öffnung (50) direkt mit einer polykristallinen Siliciumschicht (18) in Kontakt kommt, die auf der Vorderseite des ersten verdünnten Substrats ausgebildet ist, wobei die polykristalline Siliciumschicht (18) selbst mit einer Metallschicht (M1) der integrierten Schaltung in Kontakt ist, die auf der Vorderseite des verdünnten Siliciumsubstrats ausgebildet ist.

7. Bauelement nach Anspruch 6, **dadurch gekennzeichnet, dass** die in der Halbleiterschicht (12) ausgebildete Öffnung (50) in einer Halbleiterschichtinsel ausgebildet ist, die durch einen diese Insel umgebenden Graben elektrisch vollkommen vom Rest der Halbleiterschicht (12) isoliert ist.

8. Elektronisches Bauelement nach einem der Ansprüche 6 und 7, **dadurch gekennzeichnet, dass** das Übertragssubstrat (30) ein IC-Chip ist, wobei die Vorderseiten der beiden integrierten Schaltungen aneinander geklebt sind, wobei der auf der Rückseite der Halbleiterschicht (12) gebildete Metallschichtabschnitt (80) außer dem Verbindungskontaktstück eine leitende Verbindung umfasst, die das Kontaktstück mit einer leitenden Schicht der Vorderseite der zweiten integrierten Schaltung durch eine andere Öffnung verbindet, die in der Halbleiterschicht und durch die Isolierschichten gebildet sind, die die Halbleiterschicht der leitenden Schicht der zweiten integrierten Schaltung trennen.
